# EUROPEAN PATENT APPLICATION

(11) **EP 3 239 351 A1**
(43) Date of publication of application: **01.11.2017**
(21) Application number: 15872645.5
(22) Date of filing: 01.12.2015
(51) Int. Cl.: C23C 16/503, C23C 16/44, H01L 21/31, H01L 21/365, H05H 1/46

(54) **PLASMA CVD DEVICE**

(30) Priority: 22.12.2014 JP 2014259378
(71) Applicant: Asahi Glass Company, Limited, Tokyo 100-8405 (JP)
(72) Inventor: KAWAHARA,Hirotomo, Tokyo 100-8405 (JP); MAESHIGE,Kazunobu, Tokyo 100-8405 (JP); AOMINE,Nobutaka, Tokyo 100-8405 (JP); HANEKAWA,Hiroshi, Tokyo 100-8405 (JP)
(74) Representative: Müller-Boré & Partner Patentanwälte PartG mbB
(86) International application number: PCT/JP2015/083792
(87) International publication number: WO 2016/104076

(57) **Abstract**

A plasma CVD apparatus includes a plasma source connected to an alternating current power supply or two or more alternating current power supplies, configured to generate plasma; and a magnet array configured by a plurality of magnets. The plasma source has an electrode group, which is configured by arranging n electrodes (n being a positive even integer), in an order of electrode numbers. Each of the electrodes of the electrode group is connected to the alternating current power supply. An exit of a flow channel for a precursor gas is formed between adjacent electrodes of the electrode group. The magnet array is arranged so that a north pole or a south pole of each of the magnets is facing the plasma source. In the magnet array, for at least one pair of adjacent two magnets, poles facing the plasma source are arranged to be the same.

## Description

### BACKGROUND OF THE INVENTION

### [Technical Field]

The disclosure herein generally relates to a plasma CVD apparatus.

### [Description of Related Art]

A plasma-enhanced chemical vapor deposition (PECVD) technique (in the following, referred to as a "plasma CVD technique") is a type of chemical vapor deposition (CVD) technique that can deposit chemically a film of various materials on a surface of a body to be processed by employing plasma. The plasma CVD technique is widely used for manufacturing, for example, semiconductor elements.

A plasma CVD apparatus used for the plasma CVD technique is equipped with a plasma source. Normally, the plasma source includes a pair of electrodes connected to a high-frequency AC power supply with a frequency of, for example, 13.56 MHz. When a discharge starts between the electrodes, plasma is formed between the electrodes. When a precursor gas is supplied into the plasma in this state, atoms and/or molecules of the precursor gas are excited and made to be chemically active. Then, a chemical reaction occurs, and a film of an object substance can be deposited on the surface of the body to be processed.

In Recent times, instead of the high-frequency AC power supply, a plasma source equipped with a low-frequency AC power supply of, for example, on the order of kHz, has been disclosed (See Patent Document 1). Patent Document 1 discloses that plasma can be provided stably by using such a plasma source.

Moreover, a plasma source, in which four power supplies are arranged, and a space for supplying a precursor gas is provided between adjacent electrodes, in order to permit a large-area film deposition, has been disclosed (See Patent Document 2).

### [Citation List]

### [Patent Literature]

[PTL 1] Japanese Translation of PCT International Application Publication No. JP-T-2011-530155
[PTL 2] WO 2014/069309

### SUMMARY OF THE INVENTION

### [Technical Problem]

Generally, in the plasma CVD apparatus, it is known that with increasing a deposition rate, a denseness of the deposited film tends to decrease. Therefore, in order to obtain a dense film by using the plasma CVD process, at the expense of the deposition rate, it is often necessary to employ a sufficiently small deposition rate. However, there is a problem that such reduction of the deposition rate leads to a decrease in process efficiency upon depositing on a body to be large-area processed, for example.

The present invention was made in view of such a problem, and it is an object of the present invention to provide a plasma CVD apparatus that can deposit a dense film without excessively reducing the deposition rate.

### [Solution to Problem]

It is a general object of at least one embodiment of the present invention to provide a plasma CVD apparatus that substantially obviates one or more problems caused by the limitations and disadvantages of the related art.

In the present invention, a plasma CVD apparatus including a plasma source connected to an alternating current power supply or two or more alternating current power supplies, configured to generate plasma; and a magnet array configured by a plurality of magnets, the plasma source having an electrode group, the electrode group being configured by arranging n electrodes (n being an even integer greater than or equal to two) including a first electrode and a second electrode, in an order of electrode numbers from the first electrode, each of the electrodes of the electrode group being connected to the alternating current power supply, an exit of a flow channel for a precursor gas being formed between adjacent electrodes of the electrode group, the magnet array being arranged so that a north pole or a south pole of each of the magnets is facing the plasma source, and in the magnet array, for at least one pair of adjacent two magnets, poles facing the plasma source being arranged to be the same, is provided.

### [Advantageous effect of Invention]

The present invention can provide a plasma CVD apparatus that can deposit a dense film without excessively reducing a deposition rate.

### BRIEF DESCRIPTION OF THE DRAWINGS

Other objects and further features of embodiments will become apparent from the following detailed description when read in conjunction with the accompanying drawings, in which:
[FIG. 1] FIG. 1 is a diagram schematically depicting an example of a configuration of a plasma CVD apparatus according to an embodiment.
[FIG. 2] FIG. 2 is a diagram schematically depicting another example of the configuration of the plasma CVD apparatus according to the embodiment.
[FIG. 3] FIG. 3 is a diagram depicting an example of a result of evaluation by simulation for an influence of a magnet array on a magnetic field.
[FIG. 4] FIG. 4 is a diagram depicting another example of another result of evaluation by simulation for the influence of the magnet array on the magnetic field.
[FIG. 5] FIG. 5 is a diagram schematically depicting yet another example of the configuration of the plasma CVD apparatus according to the embodiment.
[FIG. 6] FIG. 6 is a diagram schematically depicting an example of a configuration of an electrode group in the plasma CVD apparatus and surroundings thereof, according to the embodiment.
[FIG. 7] FIG. 7 is a diagram schematically depicting an example of a configuration of deposition equipment provided with the plasma CVD apparatus according to the embodiment.
[FIG. 8] FIG. 8 is a photograph depicting a state of plasma generated from a plasma source (electrode group) upon depositing a TiO₂ film in Example 1.
[FIG. 9] FIG. 9 is a photograph depicting a state of plasma generated from the plasma source (electrode group) upon depositing a TiO₂ film in Example 10.
[FIG. 10] FIG. 10 is a photograph depicting a state of plasma generated from the plasma source (electrode group) upon depositing a TiO₂ film in Example 13.
[FIG. 11] FIG. 11 is a photograph depicting a state of plasma generated from the plasma source (electrode group) upon depositing a TiO₂ film in Example 16.
[FIG. 12] FIG. 12 is a diagram depicting collectively relations between deposition rates and refractive indices obtained in Examples 1 to 18.

### DETAILED DESCRIPTION OF THE PREFERRED EMBODIMENTS

In the following, with reference to drawings, embodiments of the present invention will be described.

### (First plasma CVD apparatus)

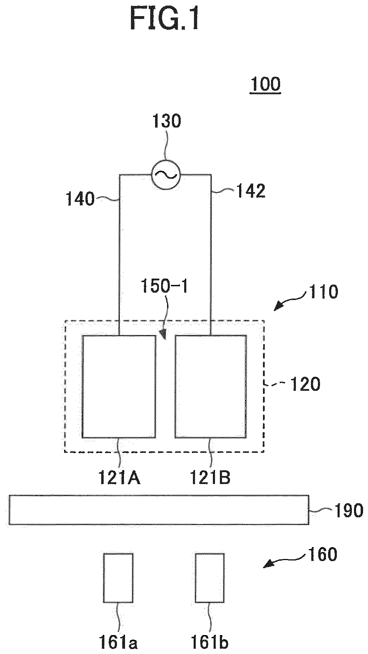

With reference to FIG. 1, a plasma CVD apparatus according to an embodiment of the present invention (in the following, referred to as a "first plasma CVD apparatus") will be described.

FIG. 1 schematically depicts an example of a configuration of the first plasma CVD apparatus.

As illustrated in FIG. 1, the first plasma CVD apparatus 100 includes a plasma source 110 connected to an alternating current power supply 130. The plasma source 110 is arranged on one side (upper side) of a body to be processed 190. Moreover, the first plasma CVD apparatus 100 includes a magnet array 160 arranged on the other side (lower side) of the body to be processed 190. Therefore, the plasma source 110 and the magnet array 160 are arranged so as to face each other via the body to be processed 190.

In a normal case, the first plasma CVD apparatus 100 includes a support base for supporting the body to be processed 190, a holder, a conveyance base, and/or the like, which are omitted for the purpose of clarification.

The plasma source 110 includes an electrode group 120 configured by arranging a plurality of electrodes in a row. For example, in the example illustrated in FIG. 1, the electrode group 120 is configured by arranging a first electrode 121A and a second electrode 121B, aligning with each other.

Between the first electrode 121A and the second electrode 121B, a first space 150-1 for supplying a precursor gas is formed near both the electrodes. As the precursor gas, depending on a composition of the intended film, for example, silane, disilane, tetraethoxysilane (TEOS), hexamethyldisiloxane (HMDSO), tetramethyldisiloxane (TMDSO), trisilylamine, titanium tetrachloride, ortho tetraisopropyl titanate (TTIP), tetrakis dimethylamino titanium (TDMAT), zirconium tetrabutoxide (ZTB), aluminum tetrachloride, trimethyl aluminum, aluminum sec-butoxide, tin tetrachloride, and monobutyl tin trichloride (MBTC) can be suitable for user.

To the respective electrodes 121A, 121B configuring the electrode group 120, the alternating current power supply 130 is connected. A frequency of the alternating current power supply 130 is, for example, within a range of 5 kHz to 500 kHz. The alternating current power supply 130 includes a first wiring 140 and a second wiring 142. A polarity of the second wiring 142 is opposite to a polarity of the first wiring 140. The first wiring 140 is connected to the first electrode 121A, and the second wiring 142 is connected to the second electrode 121B.

The magnet array 160 is configured by a plurality of magnets. In the example, illustrated in FIG. 1, the magnet array 160 is configured by two magnets, i.e. a first magnet 161a and a second magnet 161b. The number of magnets is not particularly limited as long as the number is two or more. The number of magnets may be three, and the number may be four or more.

In the first plasma CVD apparatus 100, two magnets 161a, 161b in the magnet array 160 are arranged so that polarities on the side facing the body to be processed 190, i.e. the electrode group 120 are the same.

In the example, illustrated in FIG. 1, both the first magnet 161a and the second magnet 161b are arranged in the direction where south poles are located on the upper side, i.e. the south poles are located on the electrode group 120 side. Alternatively, both the first magnet 161a and the second magnet 161b may be arranged in the direction where north poles are located on the upper side, i.e. the north poles are located on the electrode group 120 side.

In the following description, an arrangement mode of magnets in the magnet array 160, described as above, i.e. the arrangement state where the polarities of the two adjacent magnets on the side facing the electrode group 120 are the same, will be referred to as a "same polarity arrangement (of pair of adjacent magnets)".

In the case of performing a deposition on a surface of the body to be processed 190 by using the first plasma CVD apparatus 100 having the above-described configuration, an alternating current voltage is applied to both the electrodes 121A, 121B from the alternating current power supply 130 via the wirings 140 and 142. Moreover, a reaction assisting gas is supplied near the electrode group 120.

By applying the alternating current voltage, the polarities of both the electrodes 121A, 121B vary periodically. Moreover, a discharge occurs between the first electrode 121A and the second electrode 121B, and plasma is generated near both the electrodes.

Next, a precursor gas for deposition is supplied to the first space 150-1 arranged between both the electrodes 121A and 121B. The precursor gas supplied to the first space 150-1 is activated by the plasma generated near the electrodes 121A, 121B, when the precursor gas is ejected from an exit of the space 150-1. As a result, a chemical reaction occurs in the precursor gas near the body to be processed 190, and a product according to the reaction is deposited in a processing region of the body to be processed 190. According to the above-described operation, a desired film can be formed in the processing region of the body to be processed 190.

As described above, in the first plasma CVD apparatus 100, both the magnets 161a and 161b in the magnet array 160 are arranged in the "same polarity arrangement". In this case, as will be described later in detail, a uniformity of plasma over an entire surface of the body to be processed 190 (in the following, referred to as a "processing region") located below the plasma source 110 can be enhanced, and a plasma density in the processing region can be increased significantly.

According to the above-described configuration, in the first plasma CVD apparatus 100, a chemical reaction rate of the precursor gas in the processing region of the body to be processed 190 can be increased significantly. Therefore, in the first plasma CVD apparatus 100, without sacrificing the deposition rate, as in the related art, it is possible to form a dense film in the processing region of the body to be processed 190 with a relatively great deposition rate.

Moreover, according to the above-described effect, in the first plasma CVD apparatus 100, for example, upon depositing on a body to be large-area processed, without reducing process efficiency, a desired film can be formed.

### (Second plasma CVD apparatus)

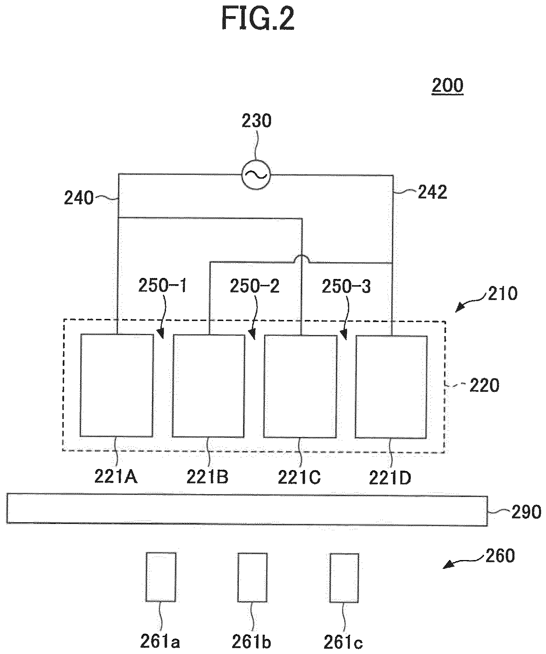

Next, with reference to FIG. 2, a plasma CVD apparatus according to another embodiment of the present invention (in the following, referred to as a "second plasma CVD apparatus") will be described.

FIG. 2 schematically depicts an example of a configuration of the second plasma CVD apparatus.

As illustrated in FIG. 2, the second plasma CVD apparatus 200 includes a plasma source 210 connected to an alternating current power supply 230. The plasma source 210 is arranged on one side (upper side) of a body to be processed 290. Moreover, the second plasma CVD apparatus 200 includes a magnet array 260 arranged on the other side (lower side) of the body to be processed 290. Therefore, the plasma source 210 and the magnet array 260 are arranged so as to face each other via the body to be processed 290.

In a normal case, the second plasma CVD apparatus 200 includes a support base for supporting the body to be processed 290, a holder, a conveyance base, and/or the like, which are omitted for the purpose of clarification.

The plasma source 210 includes an electrode group 220 configured by arranging a plurality of electrodes in a row. For example, in the example illustrated in FIG. 2, the electrode group 220 is configured by arranging a first electrode 221A, a second electrode 221B, a third electrode 221C, and a fourth electrode 221D in this order.

The number of electrodes is not necessarily limited to four. The number of electrodes may be six, and the number may be eight or more. However, the number of electrodes is an even integer.

Between adjacent electrodes of the electrodes 221A to 221D, a space for supplying a precursor gas is formed. That is, between the first electrode 221A and the second electrode 221B, a first space 250-1 is formed, between the second electrode 221B and the third electrode 221C, a second space 250-2 is formed, and between the third electrode 221C and the fourth electrode 221D, a third space 250-3 is formed.

The respective electrodes 221A to 221D configuring the electrode group 220 are connected to the alternating current power supply 230. The alternating current power supply 230 includes a first wiring 240 and a second wiring 242. A polarity of the second wiring 242 is opposite to a polarity of the first wiring 240. The first wiring 240 is connected to the first electrode 221A and the third electrode 221C. The second wiring 242 is connected to the second electrode 221B and the fourth electrode 221D.

In the example illustrated in FIG. 2, the respective electrodes 221A to 221D are connected to the single alternating current power supply 230. However, the respective electrodes 221A to 221D may be connected to a plurality of alternating current power supplies. For example, in the configuration illustrated in FIG. 2, two alternating current power supplies 230-1, 230-2 may be present, the first alternating current power supply 230-1 being connected to the first electrode 221A and the second electrode 221B, and the second alternating current power supply 230-2 being connected to the third electrode 221C and the fourth electrode 221D.

However, when the single alternating current power supply 230 is employed, the entire size of the second plasma CVD apparatus 200 can be reduced.

The magnet array 260 is configured by a plurality of magnets. In the example, illustrated in FIG. 2, the magnet array 260 is configured by three magnets, i.e. first to third magnet 261a to 261c. The number of magnets is not particularly limited as long as the number is two or more. The number of magnets may be four, the number may be five, and the number may be six or more.

The second plasma CVD apparatus 200 has a feature that at least a pair of adjacent two magnets in the magnet array 260, is arranged in the "same polarity arrangement". That is, at least a pair of adjacent magnets is arranged so that polarities on the side facing the body to be processed 290, and the electrode group 220 are the same.

For example, in the configuration illustrated in FIG. 2, both the first magnet 261a and the second magnet 261b may be arranged in the direction where south poles (or north poles) are located on the upper side, i.e. the south poles (or north poles) are located on the electrode group 220 side. Alternatively, both the second magnet 261b and the third magnet 261c may be arranged in the direction where south poles (or north poles) are located on the upper side, i.e. the south poles (or north poles) are located on the electrode group 220 side. Moreover, all the first to third magnets 261a to 261c may be arranged in the direction where south poles (or north poles) are located on the upper side, i.e. the south poles (or north poles) are located on the electrode group 220 side.

In the case of performing a deposition on a surface of the body to be processed 290 by using the second plasma CVD apparatus having the above-described configuration, an alternating current voltage is applied to the respective electrodes 221A to 221D from the alternating current power supply 230 via the wirings 240 and 242. Moreover, a reaction assisting gas is supplied near the electrode group 220.

By applying the alternating current voltage, the polarities of the respective electrodes 221A to 221D vary periodically. Moreover, for example, a discharge occurs where the first electrode 221A and the second electrode 221B form an electrode pair, and plasma is generated near both the electrodes. Moreover, a discharge occurs where the second electrode 221B and the third electrode 221C form an electrode pair, and plasma is generated near both the electrodes. Furthermore, a discharge occurs where the third electrode 221C and the fourth electrode 221D form an electrode pair, and plasma is generated near both the electrodes.

According to the periodical variation of the voltage polarities, with respect to a given time, the polarities of the respective electrodes are, in the order from the first electrode 221A, negative-positive-negative-positive (or positive-negative-positive-negative).

Next, a precursor gas for deposition is supplied from the first space 250-1 to the third space 250-3. The precursor gas supplied to the respective spaces is activated by the plasma generated near the corresponding electrodes of the electrodes 221A to 221D, when the precursor gas is ejected from exits of the respective spaces 250-1 to 250-3. As a result, a chemical reaction occurs in the precursor gas near the body to be processed 290, and a product according to the reaction is deposited in a processing region of the body to be processed 290. According to the above-described operation, a desired film can be formed in the processing region of the body to be processed 290.

As described above, in the second plasma CVD apparatus 200, at least a pair of magnets in the magnet array 260 is arranged in the "same polarity arrangement". In this case, as will be described later in detail, a uniformity of plasma over an entire surface of the body to be processed 290 can be enhanced, and a plasma density in the processing region can be increased significantly.

According to the above-described configuration, also in the second plasma CVD apparatus 200, a chemical reaction rate of the precursor gas in the processing region of the body to be processed 290 can be increased significantly. Therefore, it is possible to form a dense film in the processing region of the body to be processed 290 with a relatively great deposition rate.

Moreover, according to the above-described effect, in the second plasma CVD apparatus 200, for example, upon depositing on a body to be large-area processed, without reducing process efficiency, a desired film can be formed.

### (Regarding "same polarity arrangement")

As described above, the plasma CVD apparatus according to the present invention has the feature that at least a pair of adjacent two magnets in the magnet array is arranged so as to be the "same polarity arrangement". In the following, the feature will be examined.

Generally, behavior of a charged particle such as plasma is susceptible to a magnetic field. For example, when a magnet is present, a charged particle is known to spiral around a magnetic field line generated by the magnet. Therefore, also in a plasma CVD apparatus, when a magnet is arranged on a lower side of a plasma source, behavior of plasma generated from the plasma source and a plasma density within a space are considered to be able to be controlled.

The inventors of the present application, under the above-described consideration, have performed assiduous research and development for a relation between a form of a magnet array arranged on a low side of a plasma source and behavior of plasma. As a result, the inventors of the present application have found that when adjacent two magnets in the magnet array are arranged so as to be the "same polarity arrangement", a "null-point" occurs in a processing region (and in its vicinity, to which the following applies similarly) of a processed substrate, and thereby the plasma density can be increased significantly.

The "null-point" means a position in a space at which magnetic field lines of opposite directions cancel each other and thereby a magnetic force is absent.

The reason why the plasma density can be increased by forming a null-point in the processing region of the processed substrate is considered to be that a charged particle exhibits behavior of irregular motion near the null-point and a travel distance of the charged particle becomes longer (i.e. longer time is required for motion). That is, it is considered that when a null-point is present in the processing region of the processed substrate, plasma occurs more easily to remain in such a region, and as a result, the plasma density is enhanced. When the plasma density is increased, a chemical reaction is likely to occur. Therefore, it is considered that, with the magnet array in the "same polarity arrangement", even in a relatively short reaction time period (i.e. with a great deposition rate), a dense film can be formed in the processing region of the processed substrate.

From the above-described standpoint, null-points are preferably formed in the processing region in the body to be processed to be as numerous as possible. Moreover, null-points are preferably formed in the processing region in the body to be processed at regular intervals.

In the example of the second plasma CVD apparatus 200, illustrated in FIG. 2, three magnets 261a to 261c configuring the magnet array 260 are preferably arranged at regular intervals (e.g. as illustrated in FIG. 2, in the form in which three magnets 261a to 261c are arranged approximately below the spaces 250-1 to 250-3, respectively), and all the magnets 261a to 261c are preferably arranged so that south poles (or north poles) are located on the upper side, i.e. on the electrode group 220 side.

In this case, uniformity of plasma in the processing region can be enhanced, and over the entire processing region a plasma density can be increased uniformly.

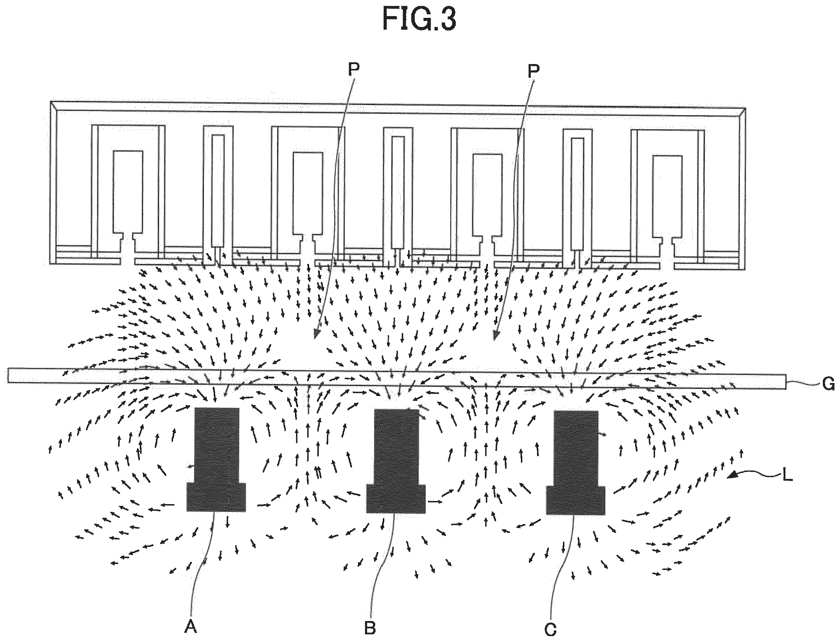

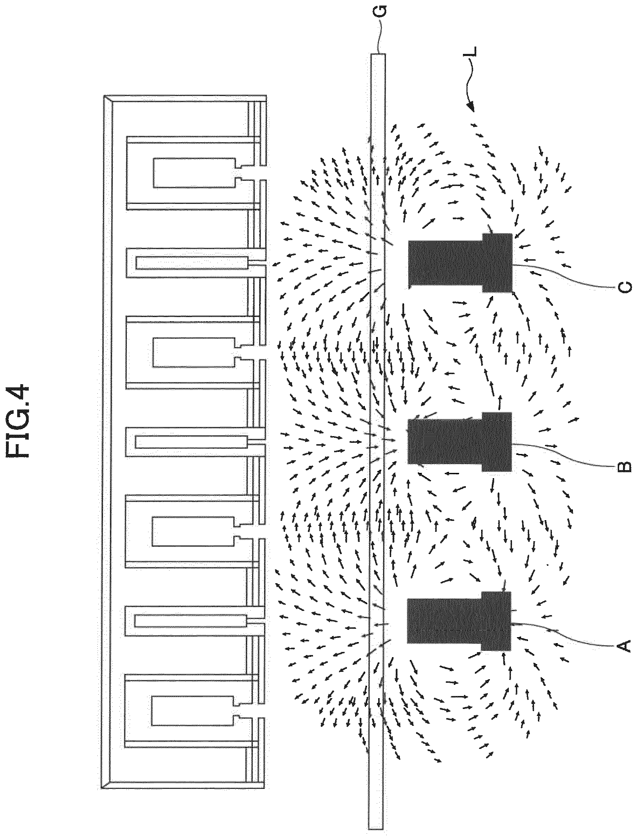

FIG. 3 and FIG. 4 depict results of evaluation by simulation for the influence of the difference in the arrangement of magnets on a magnetic field.

FIG. 3 depicts a distribution of magnetic field lines (result of simulation) in the case where polarities of all the three magnets A to C configuring the magnet array L are arranged in the same direction, that is, south poles of the magnets A to C are located on the upper side, i.e. on the body to be processed G side. FIG. 4 depicts a distribution of magnetic field lines (result of simulation) in the case where a pair of adjacent two magnets arranged in the "same polarity arrangement" is absent in the magnet array L. That is, in FIG. 4, the magnet array L is configured so that the polarities of the upper side of the respective magnets A to C are exchanged alternately, such as south pole/north pole/south pole, in order from the magnet A.

FIG. 3 and FIG. 4 do not include information on strength of magnetic field lines. That is, each of the drawings indicates a direction of a magnetic field line at each position by a direction of an arrow, but a length of the arrow does not correspond to strength of the magnetic field line.

In the case of FIG. 3, it is found that two null-points P are formed. Especially, these null-points P are formed at regular intervals in the processing region of the body to be processed S. In the case of FIG. 4, that is, in the case where a pair of adjacent two magnets arranged in the "same polarity arrangement" is absent in the magnet array L, a null-point P is not formed in the processing region.

In this way, it is considered that when adjacent two magnets in the magnet array are arranged in the "same polarity arrangement", a null-point is generated in the processing region of the body to be processed, and thereby the plasma density in the processing region can be increased. Moreover, it is considered that when the "same polarity arrangement" is employed, a dense film can be formed in the processing region of the body to be processed at a relatively great deposition rate.

The above-described consideration has been performed based on experimental results that can be used at present. However, it should be noted that, the effect by the "same polarity arrangement" of the pair of adjacent magnets may in actuality also be expressed by another mechanism. That is, in the present invention, the arrangement form of magnets in the magnet array is important. As long as the above-described arrangement form is included, such a plasma CVD apparatus belongs to the category of the present invention.

### (Third plasma CVD apparatus)

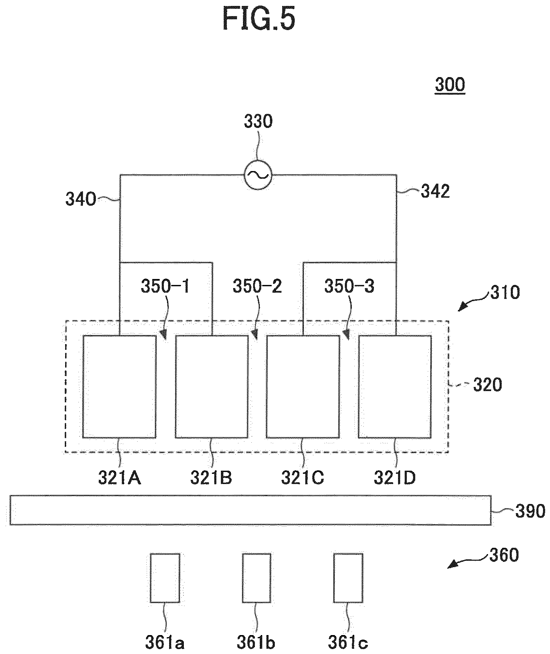

Next, with reference to FIG. 5, a plasma CVD apparatus according to yet another embodiment of the present invention (in the following, referred to as a "third plasma CVD apparatus") will be described.

FIG. 5 schematically depicts an example of a configuration of the third plasma CVD apparatus.

As illustrated in FIG. 5, the third plasma CVD apparatus has fundamentally the same configuration as the above-described second plasma CVD apparatus 200, illustrated in FIG. 2. Therefore, in the third plasma CVD apparatus illustrated in FIG. 5, to the same member as that of the second plasma CVD apparatus 200 illustrated in FIG. 2, a reference numeral obtained by adding 100 to the reference numeral used in FIG. 2 will be assigned. For example, the third plasma CVD apparatus 300 includes a plasma source 310 connected to an alternating current power supply 330, a magnet array 360, and the like.

However, in the third plasma CVD apparatus 300, a connection system between respective electrodes 321A to 321D configuring an electrode group 320 and the alternating current power supply 330 is significantly different from the second plasma CVD apparatus 200. That is, a first wiring 340 of the alternating current power supply 330 is connected to a first electrode 321A and a second electrode 321B, and a second wiring 342 is connected to a third electrode 321C and a fourth electrode 321D.

In such a connection system, when an alternating current voltage is applied from the alternating current power supply to the respective electrodes 321A to 321D via the wirings 340 and 342, polarities of the respective electrodes 321A to 321D vary periodically. However, the polarities of the respective electrodes with respect to a given time are, different from the second plasma CVD apparatus 200, in the order from the first electrode 321A, negative-negative-positive-positive (or positive-positive-negative-negative).

For example, assume the case where the polarities of the four electrodes configuring the electrode group 320 are, in the order from the first electrode 321A, negative-negative-positive-positive. In this case, a part of electrons from the second electrode 321B are absorbed by the adjacent third electrode 321C, and another part of electrons are absorbed by the fourth electrode 321D. A part of electrons from the second electrode 321B reach the fourth electrode 321D beyond the third electrode 321C, because polarities of the third electrode 321C and the fourth electrode 321D are the same (positive polarity) and an electrode having an opposite polarity is absent between the third electrode 321C and the fourth electrode 321D. However, according to the relation of distances between electrodes, most of the electrons emitted from the second electrode 321B are absorbed by the third electrode 321C, and a fraction of the electrons proceeding to the fourth electrode 321D is considered to be small compared with a fraction of electrons absorbed by the third electrode 321C.

In the same way as above, a part of electrons from the first electrode 321A are absorbed by the third electrode 321C and another part of electrons are absorbed by the fourth electrode 321D. However, according to the relation of distances between electrodes, most of the electrons emitted from the first electrode 321A are absorbed by the third electrode 321C, and a fraction of the electrons proceeding to the fourth electrode 321D is considered to be small compared with a fraction of electrons absorbed by the third electrode 321C.

Taking into account the above-described flow of electrons, it is expected that plasma with quite high density occurs between the second electrode 321B and the third electrode 321C. Therefore, the third plasma CVD apparatus 300 can generate higher density plasma between the second electrode 321B and the third electrode 321C than the second plasma CVD apparatus 200.

Also in the third plasma CVD apparatus 300, at least a pair of adjacent two magnets in the magnet array 360 is arranged so as to be the "same polarity arrangement". That is, at least a pair of adjacent magnets is arranged so that polarities on the side facing the electrode group 320 are the same.

For example, in the configuration illustrated in FIG. 5, both the first magnet 361a and the second magnet 361b may be arranged in the direction where south poles (or north poles) are located on the upper side, i.e. the south poles (or north poles) are located on the electrode group 320 side. Alternatively, both the second magnet 361b and the third magnet 361c may be arranged in the direction where south poles (or north poles) are located on the upper side, i.e. the south poles (or north poles) are located on the electrode group 320 side. Moreover, all the first to third magnets 361a to 361c may be arranged in the direction where south poles (or north poles) are located on the upper side, i.e. the south poles (or north poles) are located on the electrode group 320 side.

Therefore, also in the third plasma CVD apparatus 300, a uniformity of plasma over an entire surface of the body to be processed 390 can be enhanced, and a plasma density in the processing region can be increased significantly.

According to the above-described configuration, also in the third plasma CVD apparatus 300, a chemical reaction rate of the precursor gas in the processing region of the body to be processed 390 can be increased significantly. Therefore, it is possible to form a dense film in the processing region of the body to be processed 390 with a relatively great deposition rate.

Moreover, according to the above-described effect, in the third plasma CVD apparatus 300, for example, upon depositing on a body to be large-area processed, without reducing process efficiency, a desired film can be formed.

### (Configuration components of plasma CVD apparatus according to the embodiment)

Next, specification or the like of main components configuring the plasma CVD apparatus according to the embodiment will be described in detail. In the following, as an example, the configuration components of the second plasma CVD apparatus 200, illustrated in FIG. 2 will be described. Therefore, in the following description, upon expressing each member, the reference numeral indicated in FIG. 2 will be used. However, it is obvious for a person skilled in the art that the following description can be applied also to the other plasma CVD apparatuses within the scope of the present invention, e.g. the first plasma CVD apparatus 100, the third plasma CVD apparatus 300, and the like, in the same way or by changing a part of the description.

### (Electrode group 220)

As described above, the electrode group 220 is configured by arranging the electrodes 221A to 221D, a number of which is an even integer, in a row. Between the adjacent electrodes, spaces for supplying a precursor gas 250-1 to 250-3 are provided, respectively.

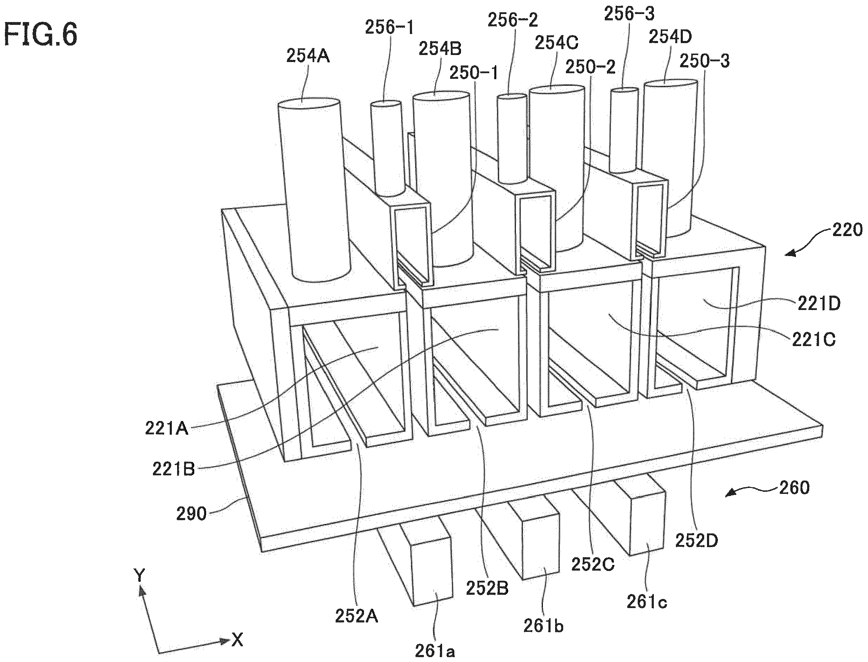

FIG. 6 schematically depicts an example of the configuration of the electrode group 220 in the second plasma CVD apparatus 200 and around the electrode group 220.

As illustrated in FIG. 6, the electrode group 220 includes, in the order from left, the first electrode 221A to the fourth electrode 221D. The respective electrodes 221A to 221D are arranged along a first direction (X-direction). Moreover, each of the electrodes 221A to 221D has a hollow electrode structure extending along a second direction (Y-direction). The electrodes 221A to 221D have slits 252A to 252D extending in the second direction (Y-direction), respectively, at the center of lower surfaces that face the body to be processed 290.

Widths of the slits 252A to 252D fall within a range of 1 mm to 10 mm, for example. Instead of the slits 252A to 252D, an aperture may be formed.

Between the first electrode 221A and the second electrode 221B, the first space 250-1 having an end portion (exit) that is opened toward the body to be processed 290 is arranged. In the same way, between the second electrode 221B and the third electrode 221C, the second space 250-2 having an end portion (exit) that is opened toward the body to be processed 290 is arranged, and between the third electrode 221C and the fourth electrode 221D, the third space 250-3 having an end portion (exit) that is opened toward the body to be processed 290 is arranged.

Moreover, the electrode group 220 includes pipes 254A to 254D for supplying a reaction assisting gas (e.g. nitrogen, oxygen, argon, and/or the like) to the respective electrodes 221A to 221D. Furthermore, the electrode group 220 includes precursor gas pipes 256-1 to 256-3 for supplying a precursor gas to the respective spaces 250-1 to 250-3.

When the electrode group 220 operates, a discharge occurs in each of the electrodes 221A to 221D.

Therefore, for example, a reaction assisting gas supplied to the pipe 254A becomes plasma in the process of passing through a hollow portion of the first electrode 221A, and ejected from the slit 252A. The same applies to the other pipes 254B to 254D. Moreover, the precursor gas supplied to the precursor gas pipe 256-1 is, after flowing in the first space 250-1, ejected from the end portion (exit), and decomposed and activated by the plasma. The same applies to the other precursor gas pipes 256-2 to 256-3.

The configuration of the electrode group 220, illustrated in FIG. 6, is an example, and the electrode group 220 may have another configuration.

### (Magnet array 260)

As described above, the magnet array 260 is configured by an array of the plurality of magnets 261a to 261c. The respective magnets 261a to 261c are preferably arranged at regular intervals.

Arrangement positions of magnets with respect to the electrode group 220 are not particularly limited. For example, the respective magnets may be arranged in a mode illustrated in FIG. 2 (and FIG. 5), i.e. immediately below the spaces 250-1 to 250-3 between the electrodes 221A to 221D corresponding to the magnets, respectively. Moreover, in the magnet array, illustrated in FIG. 2, an additional magnet may be further arranged at a position corresponding to immediately below an outer boundary of the first electrode 221A (left of the first magnet 261a) and/or a position corresponding to immediately below an outer boundary of the fourth electrode 221D (right of the third magnet 261c). Alternatively, the respective magnets may be arranged in a mode illustrated in FIG. 1, i.e. immediately below the electrodes corresponding to the magnets, respectively.

Moreover, the number of magnets is not particularly limited, but usually, the number of magnets falls preferably within a range of (number of electrodes - 1) to (number of electrodes + 1). For example, in the mode illustrated in FIG. 1, the number of magnets is the same as the number of electrodes. In the mode illustrated in FIG. 2 and FIG. 5, the number of magnets is less than the number of electrodes by one. Moreover, in FIG. 2 and FIG. 5, in the mode where additional magnets are arranged on the left of the first magnet and on the right of the third magnet, the number of magnets is greater than the number of electrodes by one.

As described above, in the magnet array 260, at least one pair of magnets adjacent to each other is required to be arranged so as to be the "same polarity arrangement".

FIG. 6, as described above, depicts an example of an arrangement relation of the magnet array 260 with respect to the electrode group 220. As illustrated in FIG. 6, each of the magnets 261a to 261c configuring the magnet array 260 has approximately a shape of a bar extending along the second direction (Y direction). In this example, the respective magnets 261a to 261c are arranged approximately below the first space 250-1, the second space 250-2 and the third space 250-3.

A material of the magnets includes a ferrite magnet, a neodymium magnet, a samarium-cobalt magnet, an alnico magnet, and the like. However, it is clear that the present invention is not limited to the above.

### (Example of application of the plasma CVD apparatus according to the embodiment)

Next, an example of deposition equipment to which the plasma CVD apparatus according to the embodiment is applied will be briefly described. In the following, the second plasma CVD apparatus 200, illustrated in FIG. 2, is employed as an example, and the deposition equipment including such an apparatus will be explained. Therefore, in the following description, upon denoting respective members of the plasma CVD apparatus, the reference numerals indicated in FIG. 2 may be used. However, it is obvious for a person skilled in the art that the following description can be applied also to the other plasma CVD apparatuses within the scope of the present invention, e.g. the first plasma CVD apparatus, the third plasma CVD apparatus, and the like, in the same way or by changing partially.

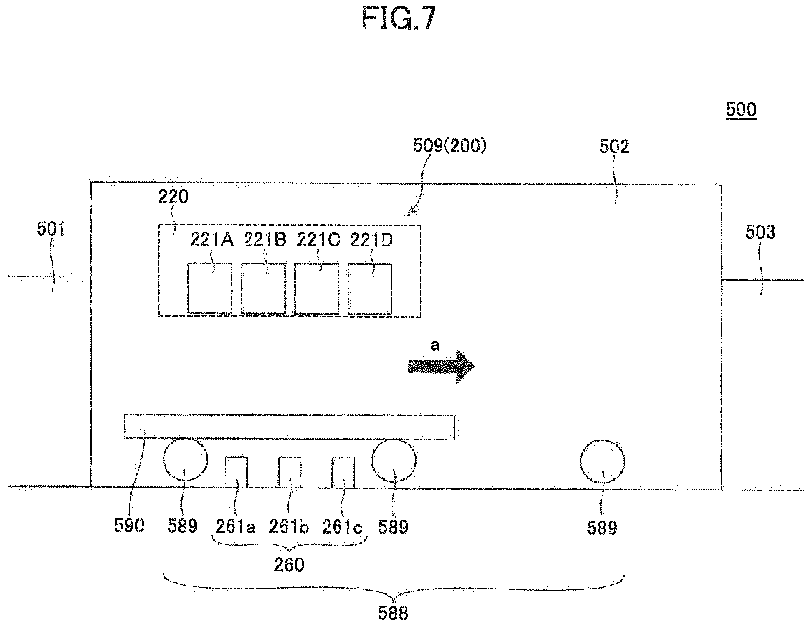

FIG. 7 schematically depicts an example of a configuration of the deposition equipment provided with the plasma CVD apparatus according to the embodiment.

In the deposition equipment 500, it is possible to deposit various films on a surface of a body to be processed 590 having a large area according to the plasma CVD process.

As illustrated in FIG. 7, the deposition equipment 500 includes an entrance chamber 501, a deposition chamber 502, and an exit chamber 503. The entrance chamber 501 and the exit chamber 503 are connected to the deposition chamber 502. In the deposition chamber 502, a plasma CVD apparatus 509 is housed. As the plasma CVD apparatus, the above-described second plasma CVD apparatus 200 is used.

Moreover, the deposition equipment 500 includes a conveyance apparatus 588 provided with a plurality of rollers 589. The conveyance apparatus 588 is housed in the deposition chamber 502, and has a function of conveying the body to be processed 590 along a conveyance direction "a" in the deposition chamber 502. The processed body includes a glass substrate, a metallic substrate, a ceramic substrate or the like.

In such deposition equipment 500, upon performing deposition for the body to be processed 590, the body to be processed 590 is first conveyed into the entrance chamber 501.

Next, the entrance chamber 501, the deposition chamber 502, and the exit chamber 503 are made to be in vacuum states. Then, the body to be processed 590 is conveyed into the deposition chamber 502. At this time, the conveyance apparatus 588 may be used.

Next, the plasma CVD apparatus 509 (i.e. the second plasma CVD apparatus 200) operates. More specifically, various gases (precursor gas, reaction assisting gas, and the like) are supplied to the second plasma CVD apparatus 200, the electrode group 220 is connected to an alternating current power supply (not shown), and a discharge starts. According to the above-described operations, plasma occurs and the deposition reaction starts.

The body to be processed 590 moves on the rollers 589 along the conveyance direction "a" by the conveyance apparatus 588. According to the above-described operation, the body to be processed 590 passes serially below the respective electrodes 221A to 221D configuring the electrode group 220. Then, on a part of the surface of the body to be processed 590, which has completely passed the second plasma CVD apparatus 200, a film with a predetermined thickness is formed.

Because the body to be processed 590 is continuously conveyed by the conveyance apparatus 588, also after the above-described deposition, deposition for the body to be processed 590 is performed continuously along the conveyance direction "a".

Afterwards, when the deposition in a required region is completed, the body to be processed 590 is ejected to the outside of the deposition equipment 500 via the exit chamber 503.

In such deposition equipment, because deposition can be performed for a body to be processed 590 while conveying the body to be processed 590, an efficiency of deposition is significantly improved. Moreover, deposition can be performed for a body to be large-area processed.

Especially, as described above, because the deposition equipment 500 is provided with the second plasma CVD apparatus 200, a plasma density in a processing region of the body to be processed 590 can be enhanced significantly. Therefore, a chemical reaction rate of a precursor gas in the processing region of the body to be processed can be enhanced significantly, and a dense film can be deposited in a relatively high deposition rate. As a result, in the deposition equipment 500, a dense film can be deposited in a state where the body to be processed 590 is conveyed with a significantly great conveyance velocity.

As described above, a configuration example of the plasma CVD apparatus according to embodiments of the present invention has been described. However, it is clear that the present invention can be applied to any type of the plasma CVD apparatus. For example, the present invention can be applied to any of a heating type plasma CVD apparatus that performs deposition in a state where a body to be processed is heated and a non-heating type plasma CVD apparatus that performs deposition in a state where a body to be processed is not heated (or in a heating state of about 60 °C at the maximum).

### EXAMPLES

Examples of the present invention will be described in the following.

### (Example 1)

By using the plasma CVD apparatus according to the embodiment of the present invention, TiO₂ films were deposited on a body to be processed. For the body to be processed, an alkali-free glass substrate was used.

For deposition equipment, the equipment as illustrated in FIG. 7 was used. Moreover, for a plasma CVD apparatus, the apparatus having the configuration as illustrated in FIG. 5 was used. That is, the apparatus has a plasma source including an electrode group configured by four electrodes, and a magnet array configured by three magnets. For the plasma source, the source having the structure as illustrated in FIG. 6 was used. Each of the three magnets in the magnet array was arranged so that a south pole was directed upwardly (the body to be processed side and the plasma source side).

For a precursor gas, titaniumtetraisopropanolate (TTIP) (flow rate: 350 sccm/m) was used, and for a reaction assisting gas, an oxygen gas (flow rate: 4000 sccm/m) was used. A pressure inside the deposition chamber was controlled to 1.0 Pa or less.

A frequency of the alternating current power supply was 40 kHz, and an electric voltage was applied so that a supplying power for a length of the plasma source was 80 kW/m.

A body to be processed before deposition was not heated. Moreover, a conveyance velocity of the body to be processed was 1.0 m/min.

After the deposition, the body to be processed was taken out from the exit chamber, and a denseness of the TiO₂ film was evaluated. Moreover, a thickness of the TiO₂ film was measured. From the thickness and the conveyance velocity of the body to be processed, the deposition rate of the TiO₂ film was calculated. The denseness of the TiO₂ film was evaluated by a refraction index. According to the knowledge of the inventors of the present invention, the refraction index can be used for an index of the denseness of the film (with greater refraction index of the TiO₂ film, the denseness tends to be higher). The refraction index of the TiO₂ film was measured as a value at a wavelength of 632 nm by an ellipsometer.

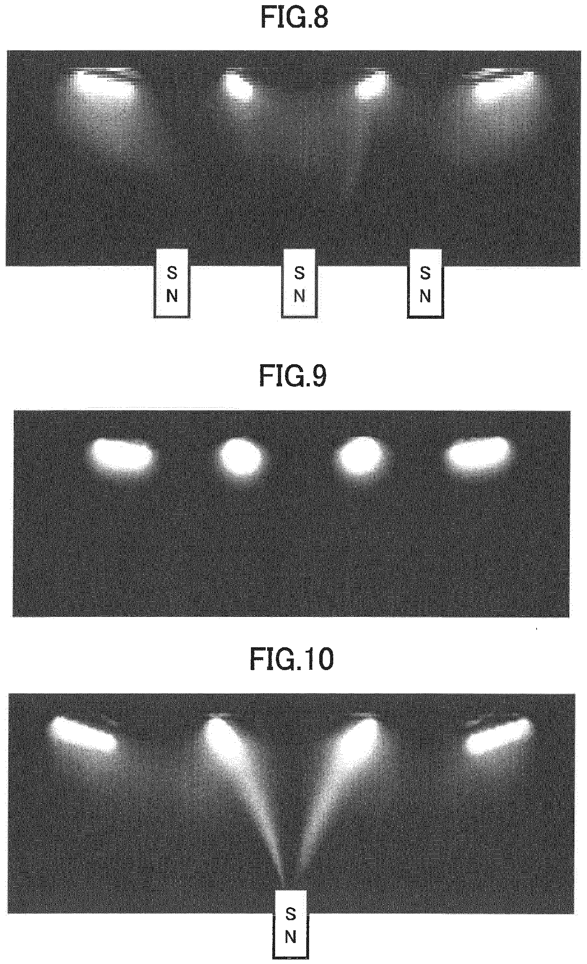

FIG. 8 schematically illustrates an example of a state of plasma generated from the plasma source (electrode group) upon depositing the TiO₂ film in Example 1. From FIG. 8, it is found that when the plasma CVD apparatus illustrated in FIG. 5 was used, over an entire processing region of the body to be processed, plasma is generated in a relatively uniform and high-density state.

### (Examples 2 and 3)

By using the same equipment as in Example 1, and with the same method, a TiO₂ film was deposited on a body to be processed body. In Examples 2 and 3, the flow rate of the precursor gas and/or the flow rate of the reaction assisting gas was different from Example 1. Other conditions were the same as in Example 1.

TABLE 1 collectively lists values of the flow rates of the precursor gas, the flow rates of the reaction assisting gas, obtained deposition rates, and the refraction indices of films in Examples 1 to 3.

**[TABLE 1]**

| example | flow rate of precursor gas (sccm/m) | flow rate of reaction assisting gas (sccm/m) | deposition rate (nm·m/min) | refraction index |
|---|---|---|---|---|
| 1 | 350 | 4000 | 50.8 | 2.26 |
| 2 | 400 | 4000 | 66.9 | 2.19 |
| 3 | 450 | 4500 | 80.4 | 2.14 |

### (Examples 4 to 6)

By using the same equipment as in Example 1, and with the same method, a TiO₂ film was deposited on a body to be processed. In Examples 4 to 6, for the plasma CVD apparatus, the apparatus having the configuration as illustrated in FIG. 2 was used. In the plasma CVD apparatus, the electrode group is configured by four electrodes, and the magnet array is configured by three magnets. For the plasma source, the source having the structure illustrated in FIG. 6 was used. Each of the three magnets in the magnet array was arranged so that a south pole was directed upwardly (the body to be processed side and the plasma source side).

Moreover, in Examples 4 to 6, values of the flow rates of the precursor gas and/or the reaction assisting gas were different from each other.

TABLE 2 collectively lists values of the flow rates of the precursor gas, the flow rates of the reaction assisting gas, obtained deposition rates, and the refraction indices of films in Examples 4 to 6.

**[TABLE 2]**

| example | flow rate of precursor gas (sccm/m) | flow rate of reaction assisting gas (sccm/m) | deposition rate (nm·m/min) | refraction index |
|---|---|---|---|---|
| 4 | 350 | 4000 | 41.3 | 2.32 |
| 5 | 400 | 4000 | 57.5 | 2.25 |
| 6 | 450 | 4500 | 72.9 | 2.21 |

### (Examples 7 to 9)

By using the same equipment as in Examples 4 to 6, and with the same method, a TiO₂ film was deposited on a body to be processed. In Examples 7 to 9, for the magnet array, four magnets were used. The respective magnets were arranged below the electrodes configuring the electrode group, respectively. Each of the four magnets in the magnet array was arranged so that a south pole was directed upwardly (the body to be processed side and the plasma source side).

Moreover, in Examples 7 to 9, values of the flow rates of the precursor gas and/or the reaction assisting gas were different from each other.

TABLE 3 collectively lists values of the flow rates of the precursor gas, the flow rates of the reaction assisting gas, obtained deposition rates, and the refraction indices of films in Examples 7 to 9.

**[TABLE 3]**

| example | flow rate of precursor gas (sccm/m) | flow rate of reaction assisting gas (sccm/m) | deposition rate (nm·m/min) | refraction index |
|---|---|---|---|---|
| 7 | 350 | 4000 | 37.7 | 2.34 |
| 8 | 400 | 4000 | 47.2 | 2.31 |
| 9 | 450 | 4500 | 62.0 | 2.24 |

### (Examples 10 to 12)

By using the same equipment as in Example 1, and with the same method, a TiO₂ film was deposited on a body to be processed. In Examples 10 to 12, for the plasma CVD apparatus, an apparatus that did not have a magnet array was used. The configuration of the plasma source was the same as that used in Example 1. That is, the plasma CVD apparatus used in Examples 10 to 12 was different from Example 1 only in that the apparatus did not include a magnet.

Moreover, in Examples 10 to 12, values of the flow rates of the precursor gas and/or the reaction assisting gas were different from each other.

FIG. 9 schematically illustrates an example of a state of plasma generated from the plasma source (electrode group) upon depositing the TiO₂ film in Example 10. From FIG. 9, it is found that when the plasma CVD apparatus that did not have a magnet array was used, plasma is biased immediately below the respective electrodes, and the plasma density in the processing region of the body to be processed was not increased greatly.

TABLE 4 collectively lists values of the flow rates of the precursor gas, the flow rates of the reaction assisting gas, obtained deposition rates, and the refraction indices of films in Examples 10 to 12.

**[TABLE 4]**

| example | flow rate of precursor gas (sccm/m) | flow rate of reaction assisting gas (sccm/m) | deposition rate (nm·m/min) | refraction index |
|---|---|---|---|---|
| 10 | 350 | 4000 | 66.7 | 1.99 |
| 11 | 400 | 4000 | 85.4 | 1.93 |
| 12 | 450 | 4500 | 91.2 | 1.91 |

### (Examples 13 to 15)

By using the same equipment as in Example 1, and with the same method, a TiO₂ film was deposited on a body to be processed. In Examples 13 to 15, for the plasma CVD apparatus, an apparatus with a magnet array having only one magnet was used. The magnet was arranged below a central portion of the plasma source, i.e. below the space between the second electrode and the third electrode. Moreover, the magnet was arranged so that a south pole was directed upwardly (the plasma source side).

The configuration of the plasma source was the same as that used in Example 1. That is, the plasma CVD apparatus used in Examples 13 to 15 was different from Example 1 only in that the apparatus included only one magnet.

Moreover, in Examples 13 to 15, values of the flow rates of the precursor gas and/or the reaction assisting gas were different from each other.

FIG. 10 schematically illustrates an example of a state of plasma generated from the plasma source (electrode group) upon depositing the TiO₂ film in Example 13. From FIG. 10, it is found that when the plasma CVD apparatus with a magnet array having only one magnet was used, although the plasma density was somewhat enhanced in the processing region of the body to be processed immediately above the magnet, the plasma density over the entire processing region was not increased greatly.

TABLE 5 collectively lists values of the flow rates of the precursor gas, the flow rates of the reaction assisting gas, obtained deposition rates, and the refraction indices of films in Examples 13 to 15.

**[TABLE 5]**

| example | flow rate of precursor gas (sccm/m) | flow rate of reaction assisting gas (sccm/m) | deposition rate (nm·m/min) | refraction index |
|---|---|---|---|---|
| 13 | 350 | 4000 | 48.4 | 2.21 |
| 14 | 400 | 4000 | 63.3 | 2.15 |
| 15 | 450 | 4500 | 93.6 | 2.05 |

### (Examples 16 to 18)

By using the same equipment as in Example 1, and with the same method, a TiO₂ film was deposited on a body to be processed. In Examples 16 to 18, the magnet array of the plasma CVD apparatus did not have the "same polarity arrangement". That is, three magnets were arranged so that upper polarities were alternately replaced in the order of south pole/north pole/south pole. The configuration of the plasma source was the same as that used in Example 1. That is, only the directions of the polarities of the three magnets were different between the plasma CVD apparatus used in Examples 16 to 18 and the apparatus in Example 1.

Moreover, in Examples 16 to 18, values of the flow rates of the precursor gas and/or the reaction assisting gas were different from each other.

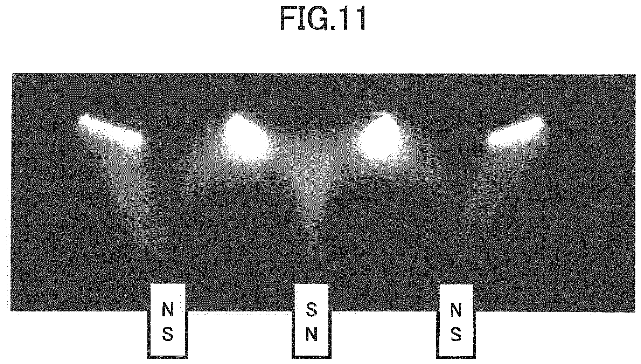

FIG. 11 schematically illustrates an example of a state of plasma generated from the plasma source (electrode group) upon depositing the TiO₂ film in Example 16. From FIG. 11, it is found that when the plasma CVD apparatus that did not have the "same polarity arrangement" was used, although the plasma density was somewhat enhanced in the processing region of the body to be processed immediately above the magnets, the plasma density over the entire processing region was not increased greatly.

TABLE 6 collectively lists values of the flow rates of the precursor gas, the flow rates of the reaction assisting gas, obtained deposition rates, and the refraction indices of films in Examples 16 to 18.

**[TABLE 6]**

| example | flow rate of precursor gas (sccm/m) | flow rate of reaction assisting gas (sccm/m) | deposition rate (nm·m/min) | refraction index |
|---|---|---|---|---|
| 16 | 350 | 4000 | 56.3 | 2.19 |
| 17 | 400 | 4000 | 79.2 | 2.10 |
| 18 | 450 | 4500 | 102.3 | 2.00 |

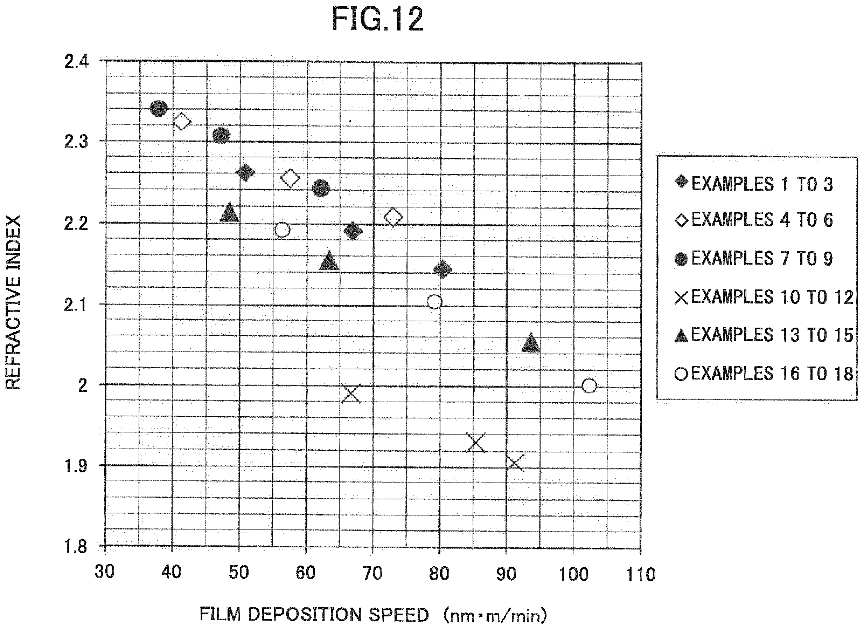

FIG. 12 collectively illustrates relations between the deposition rates and the refraction indices obtained in Examples 1 to 18.

From FIG. 12, it is shown that the results of Examples 1 to 9 are plotted in the graph above the results of Examples 10 to 18. Moreover, compared at the same deposition rate, the refraction indices of Examples 1 to 9 are greater than those of Examples 10 to 18, and it is shown that dense TiO₂ film was obtained.

In this way, it was confirmed that in Examples 1 to 9 using the plasma CVD apparatus in which the magnet array had the "same polarity arrangement", a dense film could be obtained without appreciably sacrificing the deposition rate.

### (Example 19)

By using the plasma CVD apparatus according to the embodiment, deposition of a SiO₂ film was performed on a body to be processed. For the body to be processed, an alkali-free glass substrate was used.

For the deposition equipment, the equipment illustrated in FIG. 7 was used. Moreover, for the plasma CVD apparatus, the apparatus having the configuration illustrated in FIG. 5 was used. That is, the apparatus has a plasma source including an electrode group configured by four electrodes and a magnet array configured by three magnets. For the plasma source, the source having the structure illustrated in FIG. 6 was used. Each of the three magnets in the magnet array was arranged so that a south pole was directed upwardly (the body to be processed side and the plasma source side).

For the precursor gas, tetra methyl di siloxane (TMDSO) (flow rate: 200 sccm/m) was used. For the reaction assisting gas, an oxygen gas (flow rate: 5000 sccm/m) was used. The pressure inside the deposition chamber was controlled to 1.8 Pa.

A frequency of the alternating current power supply was 40 kHz, and an electric voltage was applied so that a supplying power for a length of the plasma source was 40 kW/m.

A body to be processed before deposition was not heated. Moreover, a conveyance velocity of the body to be processed was 1.0 m/min.

After the deposition, the body to be processed was taken out from the exit chamber, and a denseness of the SiO₂ film was evaluated. Moreover, a thickness of the SiO₂ film was measured. From the thickness and the conveyance velocity of the body to be processed, the deposition rate of the SiO₂ film was calculated. The denseness of the SiO₂ film was evaluated by an amount of carbon in the film. According to the knowledge of the inventors of the present invention, the amount of carbon in the SiO₂ film can be used for an index of the denseness of the film (with a smaller amount of carbon in the SiO₂ film, the denseness tends to be higher). The amount of carbon in the SiO₂ film was measured by an X-ray Photoelectron Spectroscopy (XPS) (by ULVAC-PHI, incorporated. Versa Probe PHI 5000)

### (Example 20)

By using the same equipment as in Example 19, and with the same method, a SiO₂ film was deposited on a body to be processed. In Example 20, for the plasma CVD apparatus, an apparatus that did not have a magnet array was used. The configuration of the plasma source was the same as that used in Example 19. That is, the plasma CVD apparatus used in Example 20 was different from Example 19 only in that the apparatus did not include a magnet.

### (Example 21)

By using the same equipment as in Example 20, and with the same method, a SiO₂ film was deposited on a body to be processed. Example 21 is different from Example 20 in that a supplying power was 80 kW.

TABLE 7 collectively lists values of the supplying powers, the flow rates of the precursor gas, the flow rates of the reaction assisting gas, obtained deposition rates, and the amounts of carbon in the SiO₂ film in Examples 19 to 21.

**[TABLE 7]**

| example | supplying power (kW/m) | flow rate of precursor gas (sccm/m) | flow rate of reaction assisting gas (sccm/m) | deposition rate (nm·m/min) | amount of carbon in SiO₂ film (ac%) |
|---|---|---|---|---|---|
| 19 | 40 | 200 | 5000 | 187.0 | 0.18 |
| 20 | 40 | 200 | 5000 | 206.3 | 1.14 |
| 21 | 80 | 200 | 5000 | 192.2 | 0.15 |

From TABLE 7, it was confirmed that in Example 19 using the plasma CVD apparatus in which the magnet array had the "same polarity arrangement", in comparing with Examples 20 and 21, a dense film can be obtained with a similar deposition rate and with half the electric power. That is, the power usage can be reduced.

The present application is based on and claims the benefit of priority of Japanese Priority Application No. 2014-259378 filed on December 22, 2014, the entire contents of which are hereby incorporated by reference.

### [Reference signs list]

100 first plasma CVD apparatus
110 plasma source
120 electrode group
121A,121B electrodes
130 alternating current power supply
140 first wiring
142 second wiring
150-1 first space
160 magnet array
161a,161b magnets
190 body to be processed
200 second plasma CVD apparatus
210 plasma source
220 electrode group
221A to 221D electrodes
230 alternating current power supply
240 first wiring
242 second wiring
250-1 to 250-3 spaces
252A to 252D slits
254A to 254D pipes
256-1 to 256-3 precursor gas pipes
260 magnet array
261a to 261c magnets
290 body to be processed
300 third plasma CVD apparatus
310 plasma source
320 electrode group
321A to 321D electrodes
330 alternating current power supply
340 first wiring
342 second wiring
350-1 to 350-3 spaces
360 magnet array
361a to 361c magnets
390 body to be processed
500 deposition equipment
501 entrance chamber
502 deposition chamber
503 exit chamber
509 plasma CVD apparatus
588 conveyance apparatus
589 roller
590 body to be processed
A to C magnets
G body to be processed
L magnet array
P null point

## Claims

1. A plasma CVD apparatus comprising:
a plasma source connected to an alternating current power supply or two or more alternating current power supplies, configured to generate plasma; and
a magnet array configured by a plurality of magnets,
wherein the plasma source has an electrode group,
the electrode group is configured by arranging n electrodes (n being an even integer greater than or equal to two) including a first electrode and a second electrode, in an order of electrode numbers from the first electrode,
each of the electrodes of the electrode group is connected to the alternating current power supply,
an exit of a flow channel for a precursor gas is formed between adjacent electrodes of the electrode group,
the magnet array is arranged so that a north pole or a south pole of each of the magnets is facing the plasma source, and
in the magnet array, for at least one pair of adjacent two magnets, poles facing the plasma source are arranged to be the same.

2. The plasma CVD apparatus according to claim 1,
wherein in the magnet array, for all magnets, poles facing the plasma source are arranged to be the same.

3. The plasma CVD apparatus according to claim 1 or 2,
wherein a number of magnets included in the magnet array is in a range from (n-1) to (n+1).

4. The plasma CVD apparatus according to any one of claims 1 to 3,
wherein the magnet array includes (n-1) magnets, and
wherein the magnets are arranged substantially at positions facing the exits of the flow channels for the precursor gas arranged in the electrode group, respectively.

5. The plasma CVD apparatus according to any one of claims 1 to 3,
wherein the magnet array includes n magnets, and
wherein the magnets are arranged substantially at positions facing the electrodes configuring the electrode group, respectively.

6. The plasma CVD apparatus according to any one of claims 1 to 5,
wherein an electric voltage applied to n/2 electrodes configuring the electrode group exhibits an opposite polarity to an electric voltage applied to remaining electrodes, and
wherein electric voltages of the same polarity are applied to at least one pair of two adjacent electrodes.

7. The plasma CVD apparatus according to any one of claims 1 to 5,
wherein an electric voltage applied to n/2 electrodes configuring the electrode group exhibits an opposite polarity to an electric voltage applied to remaining electrodes, and
wherein electric voltages of the same polarity are applied to even-numbered electrodes.

8. The plasma CVD apparatus according to any one of claims 1 to 7 further comprising
a conveyance unit configured to convey a body to be processed between the plasma source and the magnet array.

9. The plasma CVD apparatus according to any one of claims 1 to 8,
wherein each electrode of the electrode group includes a slit for ejecting plasma.

10. The plasma CVD apparatus according to any one of claims 1 to 9,
wherein the respective electrodes of the electrode group are connected to a single alternating current power supply.
